(19) Europäisches Patentamt / European Patent Office / Office européen des brevets

(11) **EP 3 767 827 A1**

(12) **EUROPEAN PATENT APPLICATION**

(43) Date of publication:
20.01.2021 Bulletin 2021/03

(51) Int Cl.:
H03G 3/00 *(2006.01)*     G01R 15/09 *(2006.01)*
H03G 3/30 *(2006.01)*     H03M 1/18 *(2006.01)*

(21) Application number: 20156282.4

(22) Date of filing: 10.02.2020

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: 19.07.2019 KR 20190087866

(71) Applicant: **LG Electronics Inc.**
**07336 SEOUL (KR)**

(72) Inventors:
• **Cho, Yongsoo**
08592 Seoul (KR)
• **Kim, Taekyoung**
08592 Seoul (KR)
• **Nam, Sanghoon**
08592 Seoul (KR)
• **Yim, Namsik**
08592 Seoul (KR)

(74) Representative: **Vossius & Partner**
**Patentanwälte Rechtsanwälte mbB**
**Siebertstrasse 3**
**81675 München (DE)**

(54) **RESOLUTION CONTROL APPARATUS AND RESOLUTION CONTROL METHOD**

(57)     A control apparatus that controls a resolution according to a signal of a motor is provided. The apparatus comprises a measurement unit configured to measure a voltage and an electric current of the signal, an amplification unit comprising a first variable resistor, and a micro control unit (MCU) comprising first, second, and third lookup tables. The amplification unit is configured to amplify the signal according to a first gain corresponding to a resistance value and generate an output signal.

The MCU is configured to set the resolution, divide the signal, generate the output signal, set a measurement range corresponding to a first gain, and control the resistance value. The MCU is configured to control the resistance value according to a comparison between the set measurement range, comprising a range of voltages proportional to a magnitude of the gain, and a range of possible measurement set corresponding to the signal.

FIG. 1

EP 3 767 827 A1

## Description

## BACKGROUND

## 1. Technical Field

The present disclosure relates to a resolution control apparatus and a resolution control method, and, more particularly, to a resolution control apparatus and a resolution control method that are capable of controlling a resolution of an analog-digital converter (ADC) of a micro control unit (MCU).

## 2. Description of the Related Art

With the advance in switch element technology, rated capacity is increasing, and in turn types of electronic apparatuses that use high voltage/high electric current are increasing.

In order to control a voltage/electric current that drives these electronic apparatuses, a wide range of voltage measurement has to be used. However, when a range of voltage measurement is decreased to a voltage level that is used in an ADC of an MCU, the precision of a measurement value is decreased.

In addition, in a case where noise occurs, this is erroneously recognized as a great change. Thus, when an error occurs, a position of a rotor is erroneously estimated, and control is erroneously performed. As a result, a motor can be stopped.

In the related art, in order to solve this problem, a resolution is controlled using a thermistor. However, to do this, an electric-current source circuit is necessary to make a temperature of the thermistor variable. Thus, there occurs a problem in that the cost of manufacturing a product increases and the volume of a product increases.

In addition, there is a problem in that a loss increases because an electric current for maintaining a size of a resistor has to be supplied.

In addition, there is a problem in that an error occurs in the thermistor.

[Prior Art Document]

[Patent Document]

(Patent Document 1) KR2016-0064208 A

## SUMMARY

An object of the present disclosure is to provide an embodiment that, while retaining a wide range of measurement, is capable of making a range of measurement variable by controlling a variable resistor.

Another object of the present disclosure is to provide an embodiment that is capable of improving a resolution using a variable resistor without an additional circuit.

Still another object of the present disclosure is to provide an embodiment that is capable of setting a desired resolution regardless of outside temperature using an element that is not influenced by the outside temperature.

Still another object of the present disclosure is to provide an embodiment that is capable of setting various resolutions according to a position of a variable resistor without making an amendment to a design of a sensing circuit.

Still another object of the present disclosure is to provide an embodiment that, while retaining a wide range of resistor measurement, is capable of improving a resolution and thus improving performance at a low speed/load.

Technical problems that the present disclosure attempts to solve are not limited to the technical problems described above. From the detailed description of the embodiments, other technical problems that are not mentioned would be apparent to a person of ordinary skill in the art.

According to an aspect of the present disclosure, there is provided a control apparatus that controls a resolution according to a signal of a motor, the apparatus comprising a measurement unit configured to measure a voltage and an electric current of the signal, an amplification unit comprising a first variable resistor, and a micro control unit (MCU) comprising a first lookup table, a second lookup table, and a third lookup table. The amplification unit may be configured to amplify the signal according to a first gain corresponding to a resistance value of the first variable resistor, and generate an output signal. The MCU may be configured to set the resolution corresponding to the electric current according to the first lookup table, divide the signal according to the resolution, generate the output signal, set a measurement range corresponding to a first gain, and, according to the signal, control the resistance value such that the first gain is equal to a second gain. The MCU may be further configured to control the resistance value according to a comparison between the set measurement range and a range of possible measurement. The set measurement range may comprise a range of voltages that are proportional to a magnitude of the gain and are measurable in the measurement unit, and the range of possible measurement may comprise a range that, according to the second lookup table, is set in a manner that corresponds to the signal.

In the control apparatus, the MCU may be further configured to control the resistance value according to the comparison such that the first gain is equal to the second gain.

In the control apparatus, the MCU may be further configured to control the resistance value such that the first gain is equal to the second gain, when the set measurement range is within the range of possible measurement.

In the control apparatus, the MCU may be further configured to control the resistance value such that the second gain is lower than the first gain, when the set measurement range is broader than the range of possible measurement.

In the control apparatus, the MCU may be further configured to control the resistance value such that the second gain higher than the first gain, when the set measurement range is narrower than the range of possible measurement.

In the control apparatus, the MCU may be further configured to determine whether a load connected to the motor is a first load and control the resistance value such that the second gain is lower than the first gain, when the set measurement range is broader than the range of possible measurement.

In the control apparatus, the MCU may be further configured to determine whether the load connected to the motor is a second load and control the resistance value such that the second gain is higher than the first gain, when the set measurement range is narrower than the range of possible measurement.

In the control apparatus, the first load may be higher than the second load.

In the control apparatus, voltages of the signal may comprise a first voltage and a second voltage. The amplification unit may be further configured to generate a first output voltage corresponding to the first voltage and generate a second output voltage corresponding to the second voltage. The MCU may be further configured to set a first offset voltage and a current offset voltage, corresponding to a voltage of the signal, using the third lookup table, set a first measurement position corresponding to the voltage of the signal, and set a second offset based on a comparison between the first offset voltage and the current offset voltage.

In the control apparatus, the amplification may further comprise a second variable resistor, and the second offset may correspond to a resistor value of the second variable resistor.

In the control apparatus, the MCU may be further configured to set a second offset voltage equal to the first offset value and set a first section as a first measurement position in a manner that corresponds to the second offset, when the current offset voltage is equal to the first offset voltage. The first section may be between the first voltage and the second voltage.

In the control apparatus, the MCU may be further configured to set the second offset voltage higher than the first offset voltage and set a second section as a second measurement position in such a manner as to correspond to the second offset voltage, when the current offset voltage is higher than the first offset voltage. The amplification unit may be further configured to generate the first output voltage corresponding to a third voltage and generate the second output voltage corresponding to a fourth voltage. The second section may be between the third voltage and the fourth voltage and the third voltage, and the fourth voltage may be higher than the first voltage and the second voltage.

In the control apparatus, the MCU may be further configured to set the second offset voltage lower than the first offset voltage and set a third section as a third measurement position in such a manner as to correspond to the second offset voltage, when the current offset voltage is lower than the first offset voltage. The amplification unit may be further configured to generate the first output voltage corresponding to a fifth voltage and generate the second output voltage corresponding to a sixth voltage. The third section may be between the fifth voltage and the sixth voltage, and the fifth voltage and the sixth voltage may be lower than the first voltage and the second voltage.

According to an embodiment of the present disclosure, an advantage is provided in which, although a wide range of measurement is retained, a variable resistor can be made available by controlling a variable resistor.

In addition, according to an embodiment, an advantage is provided in which a resolution can be improved using a variable resistor without an additional circuit.

In addition, according to an embodiment, an advantage is provided in which a desired resolution can be set regardless of outside temperature using an element that is not influenced by the outside temperature.

In addition, according to an embodiment, an advantage is provided in which various resolutions can be set according to a position of a variable resistor without making an amendment to a design of a sensing circuit.

In addition, according to an embodiment, an advantage is provided in which, although a wide range of resistor measurement is retained, a resolution can be provided, thereby improving performance at a low speed/load.

**BRIEF DESCRIPTION OF THE DRAWINGS**

FIG. 1 is a block diagram illustrating a configuration of a resolution control apparatus according to an embodiment of the present disclosure.
FIG. 2A is a diagram illustrating a first amplifier according to an embodiment of the present disclosure.
FIG. 2B is a diagram illustrating a second amplifier according to an embodiment of the present disclosure.
FIG. 2C is a diagram illustrating a third amplifier according to an embodiment of the present disclosure.
FIG. 2D is a diagram illustrating a fourth amplifier according to an embodiment of the present disclosure.
FIG. 3 is a diagram illustrating a wide range of measurement according to an embodiment of the present disclosure.
FIG. 4A is a diagram illustrating a measurement position according to an embodiment of the present disclosure.

FIG. 4B is a diagram illustrating a measurement position according to an embodiment of the present disclosure.

FIG. 4C is a diagram illustrating a measurement position according to an embodiment of the present disclosure.

FIG. 5A is a graph illustrating an advantage provided by a resolution control apparatus according to an embodiment of the present disclosure.

FIG. 5B is another graph illustrating an advantage provided by a resolution control apparatus according to an embodiment of the present disclosure.

FIG. 6 is a flowchart illustrating a resolution control method according to an embodiment of the present disclosure.

FIG. 7 is a flowchart illustrating a gain control method according to the embodiment of the present disclosure.

FIG. 8 is a flowchart illustrating a measurement position control method according to the embodiment of the present disclosure.

## DETAILED DESCRIPTION OF THE EMBODIMENTS

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

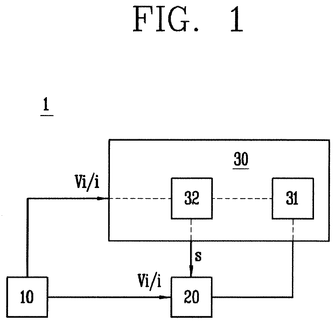

A resolution control apparatus 1 according to an embodiment will be described below with reference to FIG. 1.

FIG. 1 is a block diagram illustrating a configuration of the resolution control apparatus 1 according to the embodiment of the present disclosure.

With reference to FIG. 1, the resolution control apparatus 1 according to the embodiment may comprise a measurement unit 10, an amplification unit 20, and an MCU 30.

The measurement unit 10 may be connected to an inverter (not illustrated) and/or a battery (not illustrated). The measurement unit 10 may measure an input signal. The input signal may be a signal that is input into the inverter in order to drive a motor. Input signals may comprise an electric current and a voltage. The voltage may be a DC link voltage of the inverter, but the embodiment is not limited to this.

The inverter may be included in an electronic apparatus (for example, a motor-driven compressor, or the like) that may comprise a power conversion apparatus and a motor (not illustrated). The inverter may drive the motor under the control of the MCU 30.

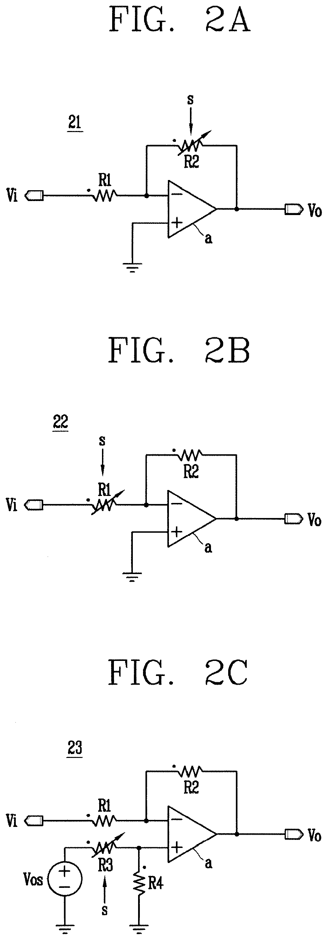

The amplification unit 20 may comprise variable resistors R1 to R4 (refer to FIGS. 2A to 2D) a resistance value of each varies according to a resistor control signal S (hereinafter referred to as a control signal) of the MCU 30, and may have gains that correspond to the resistance values of the variable resistors R1 to R4, respectively. The amplification unit 20 may amplify the input signal according to this gain and generate an output signal having an output voltage Vo (refer to FIG. 2A).

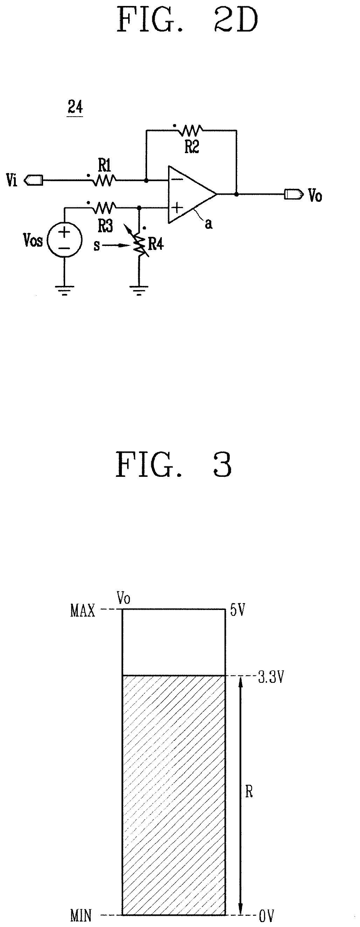

The amplification unit 20 may comprise a first amplifier 21 (refer to FIG. 2A) to a fourth amplifier 24 (refer to FIG. 2D). A specific configuration of the amplification unit 20 will be described below.

An input signal of the measurement unit 10 may be input into the MCU 30. The MCU 30 may generate the control signal S in such a manner that the resistance value of each of the multiple variable resistors included in the amplification unit 20 can be controlled, on the basis of a voltage Vi (hereinafter referred to as an input voltage) of the input signal and an electric current I (hereinafter referred to as an input electric current) of the input signal.

The MCU 30 may analyze the input signal according to a given resolution. The MCU 30 may estimate a position of a rotor of a motor (not illustrated) according to a result of the analysis and control an apparatus in which the motor is included, in a manner that corresponds to the estimated position of the rotor.

Specifically, the MCU 30 may comprise an ADC 31 and a controller 32.

The ADC 31 may divide the input voltage Vi according to the given resolution for conversion into a digital signal that is represented as a code.

For example, in a case where a resolution is 10 bits in length, the ADC 31 may divide the input voltage Vi by 210 for conversion into a digital signal. In a case where a resolution is 12 bits in length, the ADC 31 may divide the input voltage Vi by 212 for the conversion into a digital signal.

At this time, this resolution may indicate the number of bits of a signal that is output by the ADC 31. The highest-level bit may be a most significant bit (MSB), and the lowest-level bit may be a least significant bit (LSB). A resolution may be 10 bits, 12 bits, or 16 bits, but the embodiment is not limited to this.

For example, a range of operating voltages of the ADC 31 may be from 0 V to 5 V, and if the degree of resolution is 8 bits, a voltage resolution for 1 LSB may be 5 V/($2^8$) = 0.0195 V. That is, in this ADC, 1 LSB may mean 19.5 mV.

The higher the resolution for the ADC 31, the smaller voltages the input voltage Vi to be input into the controller 32 may be divided into. Although the same level of resolution is retained, the degree of the voltage for one bit (1 LSB) at the lowest level may differ according to the range of the operating voltages of the ADC 31. Therefore, the controller 32 may precisely control the motor according to the resolution for the ADC 31.

According to the embodiment, the input signal may be a signal that drives the motor, but the embodiment is not limited to this.

According to a magnitude of the input electric current i from the measurement unit 10, the controller 32 may generate the control signal S in such a manner that a range of voltages that are measurable in the measurement unit 10 (hereinafter referred to as a measurement range) is set. That is, according to the magnitude of the input electric current i, the controller 32 may decide a magnitude of a load and generate the control signal S in such a manner that a gain of the amplification unit 20 is changed. The operating voltage of the ADC 31 may be controlled according to the control signal S, and thus the measurement range may be set.

A specific method of setting the measurement range will be described below.

The controller 32 may control an offset voltage of the amplifier 20 according to the magnitude of the input voltage Vi and thus may set a measurement position of a voltage that is measured in the measurement unit 10 (hereinafter referred to as a measurement position). The controller 32 may generate the control signal S according to the magnitude of the input voltage Vi in such a manner that the offset voltage of the amplification unit 20 is controlled. A specific method of setting the measurement position will be described below.

An amplification unit according to an embodiment will be described with reference to FIGS. 2A to 2D.

FIG. 2A is a diagram illustrating a first amplifier according to an embodiment of the present disclosure.

With reference to FIG. 2A, a first amplifier 21 according to the embodiment may comprise an input terminal IN, a first resistor R1, a second resistor R2, an OP amp a, and an output terminal OUT. The first amplifier 21 may amplify the input voltage Vi of the input terminal IN according to a gain Av that is decided by the first resistor R1 and the second resistor R2, and may output the output voltage Vo to the output terminal OUT.

The input voltage Vi may be input from the measurement unit 10 into the input terminal IN.

The first resistor R1 may be connected between the input terminal IN and an inversion input terminal (-) of the OP amp a.

The second resistor R2 may be connected between the output terminal OUT and the inversion input terminal (-) of the OP amp a. The second resistor R2 may be a variable resistor of which a resistance value varies according to the control signal S.

The variable resistors R1 to R4 may be digital variable resistors (digital potentiometers (DigiPOT)), but the embodiment is not limited to this.

The OP AMP a may amplify a voltage to be input into the inversion input terminal (-), according to the gain Av that corresponds to a resistance value of the first resistor R1 and a resistance value of the second resistor R2, and may output the output voltage Vo.

The output voltage Vo of the OP amp a may be decided by the following equation 1.

[Equation 1]

$$V_o = A_v \cdot V_{in} = -\left(\frac{R_2}{R_1}\right) \cdot V_{in}$$

In Equation 1, $R_1$ may be the resistance value of the first resistor R1, and R2 may be the resistance value of the second resistor $R_2$.

The controller 32 may change the resistance value R2 according to the control signal S, and thus may control the gain Av and control a voltage to be applied to the MCU according to the controlled gain Av, thereby setting a measurement range R (refer to FIG. 3). A specific method of setting the measurement range R will be described below.

FIG. 2B is a diagram illustrating a second amplifier according to an embodiment of the present disclosure.

With reference to FIG. 2B, a second amplifier 22 according to the embodiment may comprise an input terminal IN, a first resistor R1, a second resistor R2, an OP amp a, and an output terminal OUT. The second amplifier 22 may amplify the input voltage Vi of the input terminal IN according to a gain Av that is decided by the first resistor R1 and the second resistor R2, and thus may output the output voltage Vo to the output terminal OUT.

A difference with the first amplifier 21 in FIG. 2A is that the first resistor R1 may be a variable resistor of which a resistance value varies according to the control signal S and that the second resistor R2 may not be a variable resistor. Except for this, the second amplifier 22 may be the same in configuration as the first amplifier 21. Thus, a detailed description thereof is omitted.

FIG. 2C is a diagram illustrating a third amplifier according to an embodiment of the present disclosure.

With reference to FIG. 2C, a third amplifier 23 according to the embodiment may comprise an input terminal IN, a first resistor R1, a second resistor R2, a third resistor R3, a fourth resistor R4, an OP amp a, an offset power supply Vos, and an output terminal OUT.

The input voltage Vi may be input from the measurement unit 10 into the input terminal IN.

The first resistor R1 may be connected between the input terminal IN and an inversion input terminal (-) of the OP amp a.

The second resistor R2 may be connected between the output terminal OUT and the inversion input terminal (-) of the OP amp a.

The third resistor R3 may be connected between the offset power supply Vos and a non-inversion input terminal (+) of the offset power supply Vos. The third resistor R3 may be a variable resistor of which a resistance value varies according to the control signal S.

The fourth resistor R4 may be connected between the non-inversion terminal (+) and ground.

The offset power supply Vos may be connected between the non-inversion terminal (+) and ground and may apply the offset power supply Vos to the OP amp a.

A connection may be made between the output terminal OUT and the inversion input terminal (-) of the OP amp a.

The third amplifier 23 may amplify the input voltage Vi of the input terminal IN according to a gain that is decided by the resistance value of the first resistor R1 to a resistance value of the fourth resistor R4 and an offset voltage of the offset power supply Vos, and may output the output voltage Vo to the output terminal OUT.

FIG. 2D is a diagram illustrating a fourth amplifier according to an embodiment of the present disclosure.

With reference to FIG. 2D, a fourth amplifier 24 according to the embodiment may comprise an input terminal IN, a first resistor R1, a second resistor R2, a third resistor R3, a fourth resistor R4, an OP amp a, an offset power supply Vos, and an output terminal OUT.

A difference with the third amplifier 23 in FIG. 2C is that the fourth resistor R4 may be a variable resistor of which a resistance value varies according to the control signal S and that the first resistor R1 to the third resistor R2 may not be variable resistors. Except for this, the fourth amplifier 22 may be the same in configuration as the third amplifier 23. Thus, a detailed description thereof is omitted.

The fourth amplifier 24 may amplify the input voltage Vi of the input terminal IN according to a gain that is decided by the resistance value of the first resistor R1 to the resistance value of the fourth resistor R4 and a voltage (hereinafter referred to as an offset value) of the offset power supply Vos, and may output the output voltage Vo to the output terminal OUT.

A method in which the MCU 30 according to an embodiment sets the measurement range R will be described below with reference to FIG. 3.

FIG. 3 is a diagram illustrating a measurement range R according to an embodiment of the present disclosure.

The controller 32 may set the measurement range R of the measurement unit 10 using the input electric current/the input voltage, set a first resolution for the ADC 31, and then generate the control signal S that controls an output voltage of the amplification unit 20.

With reference to FIG. 3, according to the magnitude of the input electric current i from the measurement unit 10, the controller 32 may set the measurement range R corresponding to the range of the operating voltages of the ADC 31.

For example, in a case where the operating voltage of the ADC 31 ranges from 0 V to 3.3 V and where the output voltage Vo of the amplification unit 20 ranges from a minimum voltage MIN (for example, 0 V) to a maximum voltage MAX (for example, 5 V), the controller 32 may set the measurement range R to range from a first output voltage (for example, 0 V) to a second output voltage (for example, 3.3 V), according to the magnitude of the input electric current i.

The controller 32 may comprise a first lookup table(lookup table), a second lookup table, and a third lookup table. With reference to the first lookup table, the controller 32 may set the first resolution corresponding to the input electric current. The first resolution may be 10 bits, 12 bits, or 16 bits, but the embodiment is not limited to this.

The controller 32 may decide a magnitude of a load connected to a motor, according to a magnitude of the input electric current, and may generate the control signal S according to the magnitude of the input electric current i in such a manner that the output voltage Vo of the amplification unit 20 is controlled.

For example, the controller 32 may determine whether or not the measurement range R that is set is within a given range of possible measurement (hereinafter referred to as a range of possible measurement). The range of possible measurement may be a range that is decided by looking up the input signal in the second lookup table.

As a result of the determination, the controller 32 may change the resistance values of the first resistor R1 and/or the second resistor R2 of the amplification unit 20 according to the control signal S and thus set a second resolution for the ADC 31. The controller 32 may generate the control signal S in such a manner that the output voltage of the amplification unit 20 is controlled in a manner that corresponds to the second resolution that is set.

Specifically, in a case where the measurement range R is included in the range of possible measurement, the controller 32 may generate the control signal S in such a manner that the gain of the amplification unit 20 is maintained, and set a resolution that is the same as the first resolution, as the second resolution.

In a case where the measurement range R exceeds the range of possible measurement (for example, in a case where the input electric current i from the measurement unit 10 exceeds a given reference electric current), the controller 32 may determine that the load connected to the motor is an excessive load, and may generate the control signal S in such a manner that the gain of the amplification unit 20 is scaled down. Therefore, the second resolution may be scaled down to be lower than the first resolution.

In a case where the measurement range R does not exceed the range of possible measurement (for example, in a case where the input electric current i from the measurement unit 10 is smaller than a given reference electric current), the controller 32 may determine that load connected to the motor is a low load, and may generate the control signal S in such a manner that the gain of the amplifier is scaled up. Therefore, the second resolution may be scaled up to be higher than the first resolution.

Therefore, in a case where a low load is connected to the motor, a high resolution may also be possible for a small change in electric current, and thus a position of a rotor of the motor may be measured precisely.

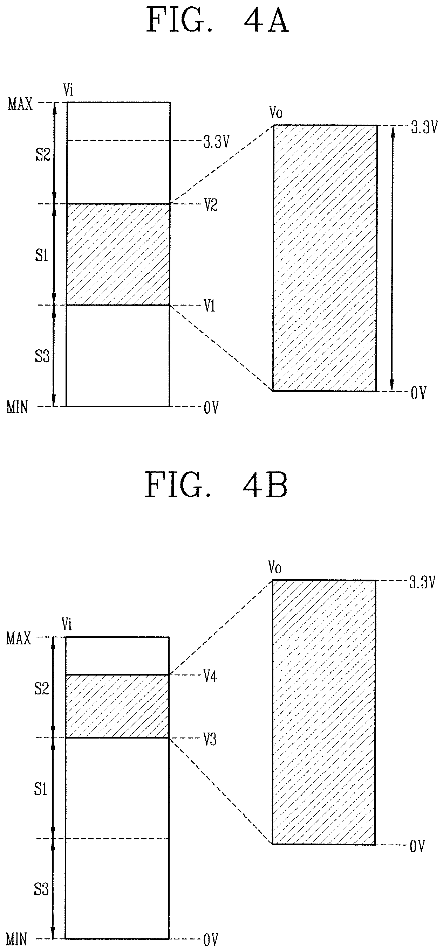

A method in which the MCU 30 according to the embodiment controls a measurement position will be described below with reference to FIGS. 4A to 4C.

FIG. 4A is a diagram illustrating a measurement position according to an embodiment of the present disclosure.

FIG. 4B is a diagram illustrating a measurement position according to an embodiment of the present disclosure.

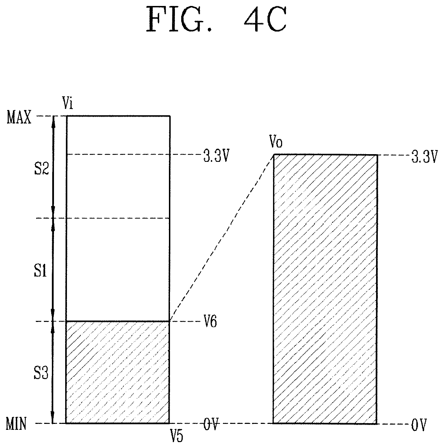

FIG. 4C is a diagram illustrating a measurement position according to an embodiment of the present disclosure.

As described with reference to FIG. 3, with reference to the first lookup table, the controller 32 may set the first resolution corresponding to the input electric current.

The controller 32 may set the measurement range R according to the magnitude of the input voltage and may generate the control signal S according to the magnitude of the input electric current in such a manner that the output voltage Vo of the amplification unit 20 is controlled.

The measurement range R may be a range of voltages that correspond to the range of the operating voltages of the ADC 31, but the embodiment is not limited to this.

Specifically, according to a section of the input voltage Vi, the controller 32 may determine whether or not the measurement range R that is set is within the range of possible measurement. The controller 32 may generate the control signal S in such a manner that resistance values of the third resistor R3 and/or the fourth resistor R4 of the amplification unit 20 are changed.

With reference to the third lookup table, the controller 32 may set a first offset corresponding to the input voltage Vi. The amplification unit 20 may generate the output voltage Vo corresponding to the first offset.

As illustrated in FIG. 4A, with reference to the third lookup table, the controller 32 may set a current offset corresponding to a current input voltage Vi. The controller 32 may compare the first offset and the current offset, and, in a case where the first offset is the same as the current offset, may generate the control signal S in such a manner as to be the same as the first offset.

The controller 32 may set a first section S1 in which the current input voltage Vi is included, as a first measurement position. That is, in a case where the current input voltage Vi lies between a first voltage V1 and a second voltage V2, the controller 32 may set the first section S1 as the first measurement position in such a manner as to correspond to the second offset.

For example, the first section S1 may be a voltage section between a minimum voltage MIN (0 V) of the input voltage Vi and a maximum voltage MAX of the input voltage Vi. Therefore, the first section S1 may be a section that corresponds to the middle portion of a range of the input voltages Vi.

The controller 32 may generate the control signal S in such a manner that the amplification unit 20 outputs the first output voltage (for example, 0 V) in a manner that corresponds to the first voltage V1 and that the amplification unit 20 outputs the second output voltage (for example, 3.3 V) in a manner that corresponds to the second voltage V2.

As illustrated in FIG. 4B, with reference to the third lookup table, the controller 32 may set the current offset corresponding to the current input voltage Vi. The controller 32 may compare the first offset and the current offset, and, in a case where the current offset is higher than the first offset, may generate the control signal S in such a manner that the second offset is higher than the first offset.

The controller 32 may set a second section S2 as a second measurement position, in a manner that corresponds to the second offset. The controller 32 may set the second measurement position to be between a third voltage V3 and a fourth voltage V4.

The second section S2 may have a higher voltage range than the first section S1 and may be a section that corresponds to an upper portion of the range of the input voltages Vi. Therefore, in the input voltage Vi, the second section S2 may lie between the second voltage V2 and the maximum voltage MAX of the input voltage Vi. The fourth voltage V4 may be included in the measurement range R, but the embodiment is not limited to this.

The controller 32 may generate the control signal S in such a manner that the amplification unit 20 outputs the first output voltage (for example, 0 V) in a manner that corresponds to the third voltage V3 and that the amplification unit 20 outputs the second output voltage (for example, 3.3 V) in a manner that corresponds to the fourth voltage V4.

As illustrated in FIG. 4C, the current offset corresponding to the current input voltage Vi may be set with reference to the third lookup table. The controller 32 may compare the first offset and the current offset, and, in a case where the current offset is lower than the first offset, may generate the control signal S in such a manner that the second offset is lower than the first offset.

The controller 32 may set a third section S3 as a third measurement position, in a manner that corresponds to the second offset. The third section S3 may be a voltage section between a fifth voltage V5 and a sixth voltage V6. The third section S3 may have a narrower voltage range than the first section S1 and may be a section that corresponds to a lower portion of the range of the input voltages Vi.

The controller 32 may generate the control signal S in such a manner that the amplification unit 20 outputs the first output voltage (for example, 0 V) in a manner that corresponds to the fifth voltage V5 and that the amplification unit 20 outputs the second output voltage (for example, 3.3 V) in a manner that corresponds to the sixth voltage V6.

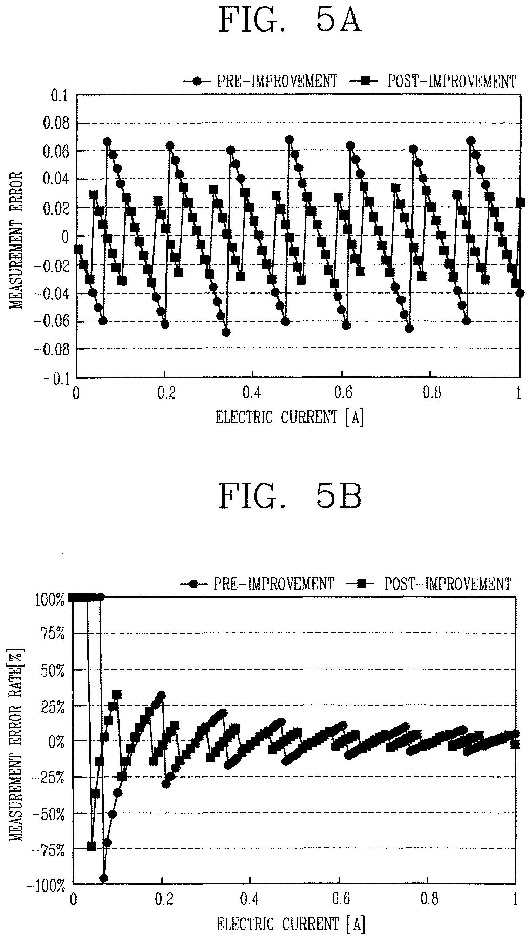

An advantage provided by the resolution control apparatus 1 according to the embodiment will be described below with reference to FIGS. 5A and 5B.

FIGS. 5A and 5B are graphs each illustrating the advantage provided by the resolution control apparatus 1 according to the embodiment of the present disclosure.

In FIG. 5A, the MCU 30 may set a measurement range corresponding to a case where the input electric current i ranges from -70 A to 70A. A measurement error in measurement unit 10 according to the embodiment is illustrated in a manner that is compared with an existing measurement error.

In addition, from FIG. 5B, it can be seen that the measurement error in the resolution control apparatus 1 according to the embodiment may converge to zero in the measurement range in FIG. 5A.

In the related art, in a case where the input electric current i ranges from -70 A to 70 A, the precision per one bit in the MCU 30 is 0.137 A.

On the other hand, even in a case where the input electric current i ranges from -35 A to 35 A, the precision per one in the MCU 30 may be 0.068 A.

Therefore, in the resolution control apparatus 1 according to the embodiment, even in a narrow range of the input electric currents i, the measurement error may be reduced to half the measurement error in the related art and the precision of measurement may be improved to two times the precision of measurement in the related art.

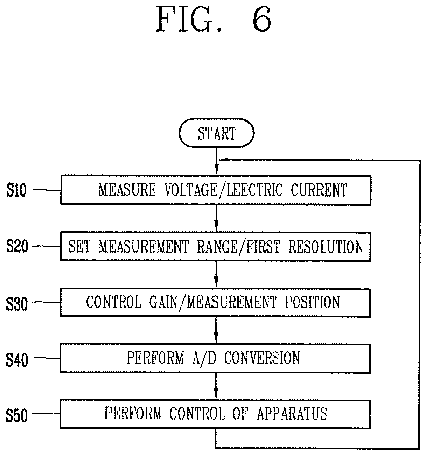

A resolution control method according to an embodiment will be described below with reference to FIG. 6.

FIG. 6 is a flowchart illustrating the resolution control method according to the embodiment of the present disclosure.

With reference to FIG. 6, in Step S10, the measurement unit 10 may measure an electric current and a voltage, and may transfer the measured electric current i and the measured voltage Vi to the MCU 30 and the amplification unit 20.

In Step S20, the controller 32 may set the measurement range according to the magnitude of the input electric current i from the measurement unit 10, and, with reference to the first lookup table, may set the first resolution corresponding to the input electric current.

In Step S30, the controller 32 may decide a magnitude of a load according to the magnitude of the input electric current i, control the resistance values of the variable resistors R1 and R2 using the control signal S, and thus control the gain of the amplification unit 20. The controller 32 may control the resistance values of the variable resistors R3 and R4 using the control signal S, according to the magnitude of the input voltage Vi, and thus control the measurement position.

In Step S40, the ADC 31 may convert an analog signal, which is input according to the decided resolution, into a digital signal.

In Step S50, the MCU 30 may analyze the digital signal that is input, according to the decided resolution. The MCU 30 may estimate a position of a rotor of a motor (not illustrated) according to a result of the analysis and control an apparatus in which the motor is included, in a manner that corresponds to the estimated position of the rotor.

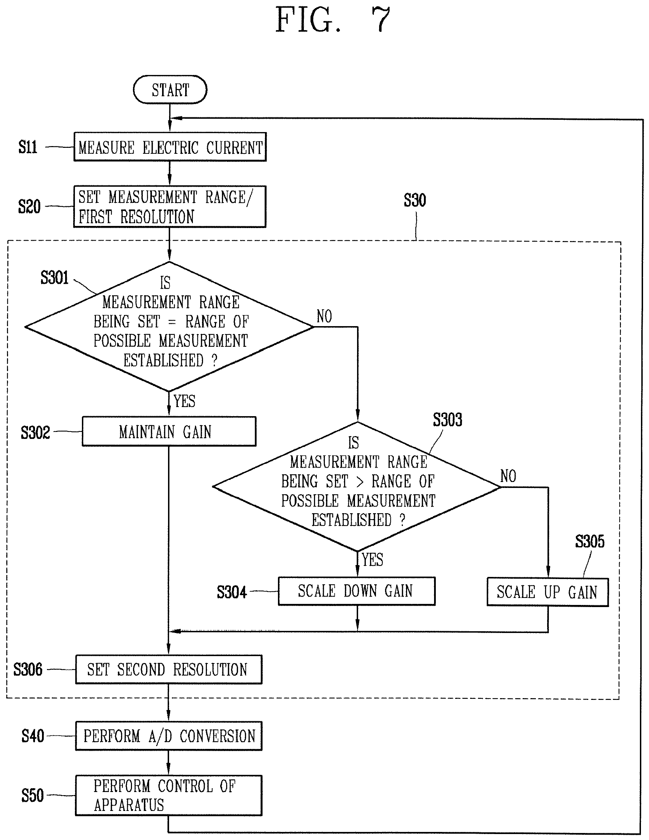

A method of controlling the gain of the amplification unit 20 and controlling the measurement position according to the embodiment, will be described below with reference to FIG. 7.

FIG. 7 is a flowchart illustrating a gain control method according to the embodiment of the present disclosure.

In Step S11, the measurement unit 10 may measure an electric current and transfer the measured electric current i to the MCU 30 and the amplification unit 20.

In Step S20, the controller 32 may set the measurement range according to the magnitude of the input electric current i from the measurement unit 10, and, with reference to the first lookup table, may set the first resolution corresponding to the input electric current.

In Step S301, the controller 32 may determine whether or not the measurement range R that is set is within the range of possible measurement.

In Step S302, in a case where the measurement range R is included in the range of possible measurement, the controller 32 may maintain the gain of the amplification unit 20.

In Step S303, in a case where the measurement range R that is set is not within the range of possible measurement, the controller 32 may determine whether or not the measurement range R exceeds the range of possible measurement.

In Step S304, in a case where the measurement range R exceeds the range of possible measurement, the controller 32 may determine that the load connected to the motor is an excessive load, generate the control signal S, and thus perform control in such a manner that the gain of the amplification unit 20 is scaled down.

In Step S305, in a case where the measurement range R that is set does not exceed the range of possible measurement, the controller 32 determine that the load connected to the motor is a low load, generate the control signal S, and thus perform control in such a manner that the gain of the amplification unit 20 is scaled up.

In Step S306, in a case where the measurement range R that is set is included in the range of possible measurement, the controller 32 may set a resolution, which is the same as the first resolution, as the second resolution. In a case where the measurement range R that is set exceeds the range of possible measurement, the controller 32 may set the second resolution that is scaled down to be lower than the first resolution. In a case where the measurement range R that is set does not exceed the range of possible measurement, the controller 32 may set the second resolution that is scaled up to be higher than the first resolution.

In Step S40, the ADC 31 may convert an analog signal, which is input according to the decided resolution, into a digital signal.

In Step S50, the MCU 30 may analyze the digital signal that is input, according to the decided resolution. The MCU 30 may estimate a position of a rotor of a motor according to a result of the analysis and control the motor in a manner that corresponds to the estimated position of the rotor.

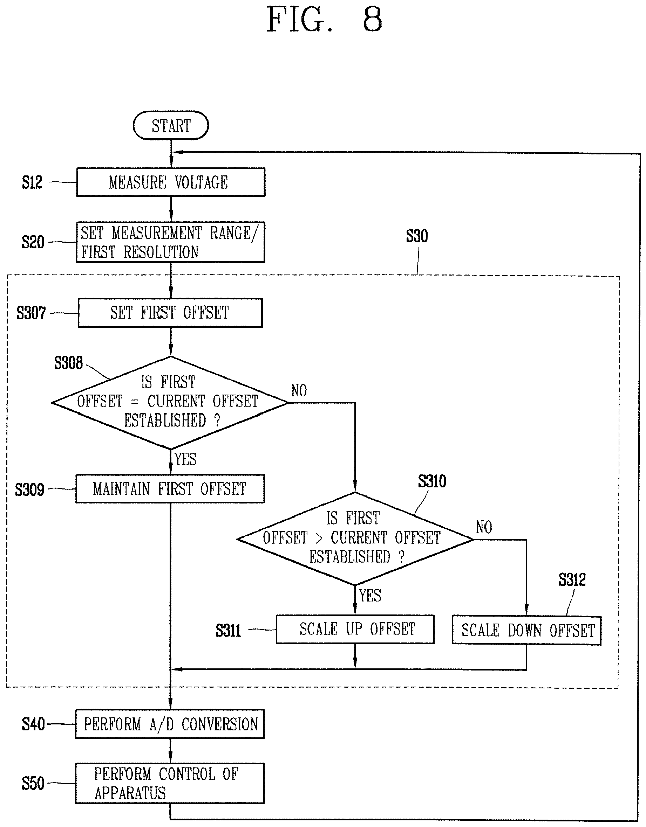

A measurement position control method according to the embodiment will be described below with reference to FIG. 8.

FIG. 8 is a flowchart illustrating the measurement position control method according to the embodiment of the present disclosure.

In Step S12, the measurement unit 10 may measure a voltage and transfer the measured voltage (Vi) to the MCU 30 and the amplification unit 20.

In Step S20, the controller 32 may set the measurement range R according to the magnitude of the input electric current i from the measurement unit 10, and, with reference to the first lookup table, set the first resolution corresponding to the input electric current.

In Step S307, with reference to the third lookup table, the controller 32 may set the first offset corresponding to the input voltage Vi.

In Step S308, with reference to the third lookup table, the controller 32 may set the current offset corresponding to the current input voltage Vi. The controller 32 may set a first section S1 in which the current input voltage Vi is included, as a first measurement position,

The controller 32 may compare the first offset and the current offset.

In Step S309, in a case where the first offset is the same as the current offset, the controller 32 may set the second offset in such a manner as to be the same as the first offset.

In Step S310, with reference to the third lookup table, the controller 32 may set the current offset corresponding to the current input voltage Vi. The controller 32 may determine whether or not the first offset exceeds the current offset.

In Step S311, in a case where the current offset is higher than the first offset, the controller 32 may generate the control signal S in such a manner that the second offset is higher than the first offset. The controller 32 may set the second section S2 as the second measurement position, in a manner that corresponds to the second offset.

In Step S312, the controller 32 may compare the first offset and the current offset, and, in the case where the current offset is lower than the first offset, may generate the control signal S in such a manner that the second offset is lower than the first offset. The controller 32 may set the third section S3 as the third measurement position, in a manner that corresponds to the second offset.

In Step S40, the ADC 31 may convert an analog signal, which is input according to the decided resolution, into a digital signal. In Step S50, the MCU 30 may analyze the digital signal that is input, according to the decided resolution. The MCU 30 may estimate a position of a rotor of a motor (not illustrated) according to a result of the analysis and control an apparatus in which the motor is included, in a manner that corresponds to the estimated position of the rotor.

Although the embodiment of the present disclosure has been described in detail, the rights scope of the present disclosure is not limited to the embodiments and various modifications and improvements thereto made by those skilled in the art using the basic concept of the present disclosure as defined in the accompanying claims will fall in the rights scope of the disclosure. Accordingly, the detailed description thereof should not be construed as restrictive in all aspects but considered as illustrative. The scope of the disclosure should be determined by reasonable interpretation of the appended claims and all changes that come within the equivalent scope of the disclosure are included in the scope of the disclosure.

**Claims**

1. A control apparatus (1) for controlling a resolution according to a signal of a motor, the apparatus (1) comprising:

    a measurement unit (10) configured to measure a voltage and an electric current of the signal;
    an amplification unit (20) comprising a first variable resistor (R1), the amplification unit (20) configured to:

        amplify the signal according to a first gain corresponding to a resistance value of the first variable resistor (R1); and
        generate an output signal; and

    a micro control unit, MCU, (30) comprising a first lookup table, a second lookup table, and a third lookup table, the MCU (30) configured to:

        set the resolution corresponding to the electric current according to the first lookup table;
        divide the signal according to the resolution;
        generate the output signal;
        set a measurement range corresponding to a first gain; and
        according to the signal, control the resistance value such that the first gain is equal to a second gain,

    wherein the MCU (30) is further configured to control the resistance value according to a comparison between the set measurement range and a range of possible measurement, and wherein the set measurement range comprises a range of voltages that are proportional to a magnitude of the gain and are measurable in the measurement unit (10), and the range of possible measurement comprises a range that, according to the second lookup table, is set in a manner that corresponds to the signal.

2. The control apparatus (1) of claim 1, wherein the MCU (30) is further configured to control the resistance value according to the comparison such that the first gain is equal to the second gain.

3. The control apparatus (1) of claim 1 or 2, wherein the MCU (30) is further configured to control the resistance value such that the first gain is equal to the second gain, when the set measurement range is within the range of possible measurement.

4. The control apparatus (1) of any one of claims 1 to 3, wherein the MCU (30) is further configured to control the resistance value such that the second gain is lower than the first gain, when the set measurement range is broader than the range of possible measurement.

5. The control apparatus (1) of any one of claims 1 to 4, wherein the MCU (30) is further configured to control the resistance value such that the second gain is higher than the first gain, when the set measurement range is narrower than the range of possible measurement.

6. The control apparatus (1) of any one of claims 1 to 5, wherein the MCU (30) is further configured to:

    determine whether a load connected to the motor is a first load; and
    control the resistance value such that the second gain is lower than the first gain, when the set measurement range is broader than the range of possible measurement.

7. The control apparatus (1) of any one of claims 1 to 6, wherein the MCU (30) is further configured to:

    determine whether the load connected to the motor is a second load; and
    control the resistance value such that the second gain is higher than the first gain, when the set measurement range is narrower than the range of possible measurement.

8. The control apparatus (1) of any one of claims 1 to 7, wherein the first load is higher than the second load.

9. The control apparatus (1) of any one of claims 1 to 8, wherein voltages of the signal comprise a first voltage and a second voltage, wherein the amplification unit (20) is further configured to generate a first output voltage corresponding to the first voltage and generate a second output voltage corresponding to the second voltage, and wherein the MCU (30) is further configured to:

    set a first offset voltage and a current offset voltage, corresponding to a voltage of the signal, using the third lookup table;
    set a first measurement position corresponding to the voltage of the signal; and
    set a second offset based on a comparison between the first offset voltage and the current offset voltage.

10. The control apparatus (1) of claim 9, wherein the amplification unit (20) further comprises a second variable resistor (R2), and wherein the second offset corresponds to a resistor value of the second variable resistor (R2).

**11.** The control apparatus (1) of claim 9 or 10, wherein the MCU (30) is further configured to:

set a second offset voltage equal to the first offset value; and
set a first section as a first measurement position in a manner that corresponds to the second offset, when the current offset voltage is equal to the first offset voltage,

wherein the first section is between the first voltage and the second voltage.

**12.** The control apparatus (1) of any one of claims 9 to 11, wherein the MCU (30) is further configured to:

set the second offset voltage higher than the first offset voltage; and
set a second section as a second measurement position in such a manner as to correspond to the second offset voltage, when the current offset voltage is higher than the first offset voltage,

wherein the amplification unit (20) is further configured to generate the first output voltage corresponding to a third voltage and generate the second output voltage corresponding to a fourth voltage,
wherein the second section is between the third voltage and the fourth voltage, and
wherein the third voltage and the fourth voltage are higher than the first voltage and the second voltage.

**13.** The control apparatus (1) of any one of claims 9 to 12, wherein the MCU (30) is further configured to:

set the second offset voltage lower than the first offset voltage; and
set a third section as a third measurement position in such a manner as to correspond to the second offset voltage, when the current offset voltage is lower than the first offset voltage,

wherein the amplification unit (20) is further configured to generate the first output voltage corresponding to a fifth voltage and generate the second output voltage corresponding to a sixth voltage,
wherein the third section is between the fifth voltage and the sixth voltage, and
wherein the fifth voltage and the sixth voltage are lower than the first voltage and the second voltage.

# FIG. 1

# FIG. 2A

# FIG. 2B

# FIG. 2C

# FIG. 2D

24

# FIG. 3

# FIG. 4A

# FIG. 4B

# FIG. 4C

# FIG. 5A

# FIG. 5B

# FIG. 6

```
                    ( START )
                        │
S10 ──  MEASURE VOLTAGE/LEECTRIC CURRENT
                        │
S20 ──  SET MEASUREMENT RANGE/FIRST RESOLUTION
                        │
S30 ──  CONTROL GAIN/MEASUREMENT POSITION
                        │
S40 ──  PERFORM A/D CONVERSION
                        │
S50 ──  PERFORM CONTROL OF APPARATUS
```

# FIG. 7

START

S11 — MEASURE ELECTRIC CURRENT

S20 — SET MEASUREMENT RANGE/ FIRST RESOLUTION

S30

S301 — IS MEASUREMENT RANGE BEING SET = RANGE OF POSSIBLE MEASUREMENT ESTABLISHED ?

NO

YES

S302 — MAINTAIN GAIN

S303 — IS MEASUREMENT RANGE BEING SET > RANGE OF POSSIBLE MEASUREMENT ESTABLISHED ?

NO

YES

S304 — SCALE DOWN GAIN

S305 — SCALE UP GAIN

S306 — SET SECOND RESOLUTION

S40 — PERFORM A/D CONVERSION

S50 — PERFORM CONTROL OF APPARATUS

# FIG. 8

```
                    ( START )
                       │
  S12 ──┤        MEASURE VOLTAGE        │
                       │                              S30
  S20 ──┤   SET MEASUREMENT RANGE/      │
         │   FIRST RESOLUTION           │
  ┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐
  S307 ──┤      SET FIRST OFFSET        │
                       │
  S308              IS FIRST                    NO
            OFFSET = CURRENT OFFSET ──────────┐
               ESTABLISHED ?                  │
                       │ YES                   │
  S309 ──┤  MAINTAIN FIRST OFFSET  │           │        S310
                       │                       IS FIRST
                       │              OFFSET > CURRENT OFFSET ──── NO
                       │                 ESTABLISHED ?              │
                       │                       │ YES                │
                       │                                          S312
                       │        S311 ──┤ SCALE UP OFFSET │  │ SCALE DOWN OFFSET │
  └ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
                       │
  S40 ──┤   PERFORM A/D CONVERSION     │
                       │
  S50 ──┤   PERFORM CONTROL OF         │
         │   APPARATUS                  │
```

Europäisches
Patentamt

European
Patent Office

Office européen
des brevets

# EUROPEAN SEARCH REPORT

Application Number

EP 20 15 6282

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 884 377 A (CHANGZHOU SOARWHALE ELECTRONIC TECH CO LTD) 14 June 2019 (2019-06-14) * abstract; claims 1-5; figures 1,2 * * table 1 * * paragraphs [0003], [0005] - [0010], [0016], [0017] * | 1-13 | INV. H03G3/00 G01R15/09 H03G3/30 H03M1/18 |
| A | EP 1 203 963 A2 (MATSUSHITA ELECTRIC IND CO LTD [JP]; TOYOTA MOTOR CO LTD [JP]) 8 May 2002 (2002-05-08) * abstract; figures 1-4 * * paragraphs [0031] - [0033], [0051] - [0053], [0084] - [0088] * | 1-13 | |
| A | US 2017/163278 A1 (FUKUDA KEISUKE [JP] ET AL) 8 June 2017 (2017-06-08) * abstract; figures 3-10,13-18 * * paragraphs [0067] - [0088] * | 1-13 | |
| A | US 2014/055291 A1 (KIMURA KAKERU [JP] ET AL) 27 February 2014 (2014-02-27) * abstract; figures 3-18,21 * * paragraphs [0123] - [0128], [0160] - [0167] * | 1-13 | TECHNICAL FIELDS SEARCHED (IPC) H03G G01R H03M |
| A | ZHOU RUOGU ET AL: "Nemo: A high-fidelity noninvasive power meter system for wireless sensor networks", 2013 ACM/IEEE INTERNATIONAL CONFERENCE ON INFORMATION PROCESSING IN SENSOR NETWORKS (IPSN), ACM, 8 April 2013 (2013-04-08), pages 141-152, XP032655994, DOI: 10.1109/IPSN.2013.6917581 [retrieved on 2014-10-07] * abstract; figures 1,4,9 * | 1-13 | |

The present search report has been drawn up for all claims

| Place of search | Date of completion of the search | Examiner |
|---|---|---|
| Munich | 14 August 2020 | Wichert, Beate |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**                    EP 20 15 6282

This annex lists the patent family members relating to the patent documents cited in the above-mentioned European search report.
The members are as contained in the European Patent Office EDP file on
The European Patent Office is in no way liable for these particulars which are merely given for the purpose of information.

14-08-2020

| Patent document cited in search report | | Publication date | Patent family member(s) | | Publication date |
|---|---|---|---|---|---|
| CN 109884377 | A | 14-06-2019 | NONE | | |
| EP 1203963 | A2 | 08-05-2002 | CN | 1352398 A | 05-06-2002 |
| | | | DE | 60122088 T2 | 18-01-2007 |
| | | | EP | 1203963 A2 | 08-05-2002 |
| | | | JP | 4210030 B2 | 14-01-2009 |
| | | | JP | 2002139522 A | 17-05-2002 |
| | | | US | 2002075004 A1 | 20-06-2002 |
| US 2017163278 | A1 | 08-06-2017 | JP | 2017108204 A | 15-06-2017 |
| | | | US | 2017163278 A1 | 08-06-2017 |
| US 2014055291 | A1 | 27-02-2014 | CN | 103493378 A | 01-01-2014 |
| | | | JP | 5657783 B2 | 21-01-2015 |
| | | | JP | WO2012144375 A1 | 28-07-2014 |
| | | | US | 2014055291 A1 | 27-02-2014 |
| | | | US | 2014347199 A1 | 27-11-2014 |
| | | | US | 2015288377 A1 | 08-10-2015 |
| | | | WO | 2012144375 A1 | 26-10-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20160064208 A